# EUROPÄISCHE PATENTSCHRIFT

(11) **EP 3 559 634 B1**
(45) Veröffentlichungstag und Bekanntmachung des Hinweises auf die Patenterteilung: **25.01.2023**
(21) Anmeldenummer: 17829657.0
(22) Anmeldetag: 22.12.2017
(51) Int. Cl.: G01N 21/3504, G01J 3/02, G01N 21/27, G01N 21/39, G01J 3/10, G01J 3/28, G01J 3/42, G01J 3/433, H01S 5/06, H01S 5/062, H01S 5/068, H01S 5/0683

(54) **VERFAHREN ZUR KORREKTUR DER WELLENLÄNGE UND DES ABSTIMMBEREICHS EINES LASERSPEKTROMETERS**
METHOD FOR CORRECTING THE WAVELENGTH AND THE TUNING RANGE OF A LASER SPECTROMETER
PROCÉDÉ DE CORRECTION DE LA LONGUEUR D'ONDE ET DE LA GAMME D'ACCORD D'UN SPECTROMÈTRE À LASER

(30) Priorität: 23.12.2016 DE 102016226215; 09.01.2017 EP 17150724
(43) Veröffentlichungstag der Anmeldung: 30.10.2019
(73) Patentinhaber: Siemens Aktiengesellschaft, 80333 München (DE)
(72) Erfinder: DEPENHEUER, Daniel, 67365 Schwegenheim (DE)
(86) Internationale Anmeldenummer: PCT/EP2017/084448
(87) Internationale Veröffentlichungsnummer: WO 2018/115472

(56) Entgegenhaltungen:
- WO-A1-2009/128138
- WO-A1-2013/191728
- CN-A- 105 021 569
- DE-A1-102011 077 634
- ZHANG KEKE ET AL: "Gas temperature measurement using first harmonic based on tunable diode laser absorption spectroscopy", PROCEEDING OF THE 11TH WORLD CONGRESS ON INTELLIGENT CONTROL AND AUTOMATION, IEEE, 29. Juni 2014 (2014-06-29), Seiten 2929-2933, XP032742785, DOI: 10.1109/WCICA.2014.7053194
- LIN XIN ET AL: "Measurements of CO concentration distribution for Mars atmospheric entry by combining OES and TDLAS", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, Bd. 9543, 4. Mai 2015 (2015-05-04), Seiten 954314-954314, XP060053609, DOI: 10.1117/12.2180592 ISBN: 978-1-62841-730-2

## Beschreibung

Die Erfindung betrifft ein Verfahren zur Korrektur der Wellenlänge und des Abstimmbereichs eines Laserspektrometers, bei dem das Licht einer wellenlängendurchstimmbaren Laserdiode nach Durchstrahlen eines Gases detektiert und ausgewertet wird, wobei die Laserdiode mit einer Stromrampe periodisch angesteuert wird, so dass bei der Detektion des Lichts ein zeitaufgelöstes Absorptionsspektrum des Gases erhalten wird, wobei
- in dem aktuell erhaltenen Absorptionsspektrum die Istposition einer Absorptionslinie des Gases mit der bei einer vorangegangenen einmaligen Justierung des Laserspektrometers detektierten und abgespeicherten Sollposition derselben Absorptionslinie verglichen wird und
- in einem Korrekturschritt bei einer Abweichung der Istposition der Absorptionslinie von der Sollposition die Temperatur der Laserdiode verändert wird, bis die Istposition der Sollposition entspricht.

Ein derartiges Verfahren ist aus der DE 10 2011 080 086 A1 oder DE 10 2013 201 459 A1 bekannt.

In der Laserabsorptionsspektroskopie wird ein Messgasgemisch mit dem Licht einer wellenlängendurchstimmbaren Laserdiode durchstrahlt und die Konzentration einer interessierenden Gaskomponente des Messgasgemischs anhand der durch die Absorption des Lichts an der Stelle einer ausgewählten Absorptionslinie der Gaskomponente hervorgerufenen Minderung der Lichtintensität bestimmt. Dabei wird die Laserdiode periodisch mit einer dreieck- oder sägezahnförmigen Strom-Zeit-Funktion (Stromrampe) angesteuert, um die Absorptionslinie der Gaskomponente wellenlängenabhängig abzutasten. Zur Erhöhung der Messgenauigkeit kann die Strom-Zeit-Funktion mit einem sinusförmigen Signal vorgegebener Frequenz f und Amplitude moduliert und das Licht bei einer höheren Harmonischen der Frequenz, üblicherweise der doppelten Frequenz 2f, phasensensitiv detektiert und ausgewertet werden (sog. Wellenlängenmodulationsspektroskopie oder WMS). Der 2f-Signalanteil in dem detektierten Licht bzw. dem erhaltenen Detektionssignal ist von dem Modulationsverhältnis, d. h. von dem Verhältnis der Modulationsamplitude zur Breite der abgetasteten Absorptionslinie, abhängig und ist bei einem Modulationsverhältnis von 2,2 maximal. (DE 10 2011 083 750 A1)

Neben dem Injektionsstrom bestimmt auch die Temperatur der Laserdiode in starkem Maße die Intensität und Wellenlänge des erzeugten Lichts, weswegen die Laserdiode auf einer Wärmesenke montiert wird, deren Temperatur geregelt wird. Aufgrund von Alterung der Laserdiode sinkt die optische Leistung und ändert sich die Wellenlänge des erzeugten Lichts, so dass Maßnahmen zur Wellenlängenstabilisierung erforderlich sind. Dazu wird, wie aus der oben genannten DE 10 2011 080 086 A1 oder DE 10 2013 201 459 A1 bekannt, neben der Absorptionslinie der zu messenden Gaskomponente auch eine Absorptionslinie eines Referenzgases oder -gasgemischs abgetastet, welches zusammen mit dem Messgas in demselben Lichtweg liegt und so gleichzeitig mit diesem durchstrahlt wird. Die Temperatur der Laserdiode bzw. der Wärmesenke wird dann über die Position der Absorptionslinie des Referenzgases in dem detektierten Absorptionsspektrum derart geregelt, dass sich diese Referenz-Absorptionslinie immer an derselben Stelle befindet. Damit liegt in erster Näherung auch die Absorptionslinie der interessierenden Gaskomponente immer an derselben Stelle der sie abtastenden Strom-Zeit-Funktion.

Aus der US 5,459,574 A ist es bekannt, einen Teil des von der Laserdiode kommenden Lichts mittels eines Strahlteilers aus dem Lichtweg zu dem Messgasgemisch auszukoppeln und nach Durchstrahlen des Referenzgases separat zu detektieren.

Aus der DE 10 2011 080 086 A1 oder DE 10 2013 201 459 A1 ist es ferner bekannt, die Laserdiode am Anfang und am Ende der Stromrampe mit unterschiedlichen Strombursts anzusteuern und anhand der unterschiedlichen Stromstärken der Strombursts und der an den Positionen der Strombursts detektierten Lichtintensitäten durch Interpolation einen Lichtintensitätswert für die Stromrampe an der Position der interessierenden Absorptionslinie zu berechnen mit dem die dort detektierte Lichtintensität normiert wird. Die Genauigkeit der Interpolation, die bei zwei unterschiedlichen Strombursts einfach linear erfolgt, kann dadurch erhöht werden, dass die Laserdiode regelmäßig mit einem zusätzlichen Stromburst angesteuert wird, dessen Stromstärke von denen der anderen Strombursts verschieden ist, und dass der Lichtintensitätswert für die Stromrampe an der Position der interessierenden Absorptionslinie anhand der Stromstärken aller Strombursts und der an den Positionen der Strombursts detektierten Lichtintensitäten durch Polynominterpolation berechnet wird.

Wie in DE 10 2011 083 750 A1 erläutert wird, müssen Laserspektrometer erstmalig bei ihrer Herstellung in Bezug auf die Wellenlänge und den Abstimmbereich eingestellt bzw. justiert werden. Die Feineinstellung der Wellenlänge kann, wie oben bereits erläutert, unter Zuhilfenahme einer Referenz-Absorptionslinie erfolgen, weil deren Wellenlängenposition mit einer höheren Genauigkeit bestimmt ist, als z. B. die Genauigkeit eines Wavemeters. Zu diesem Zweck wird eine mit einem Referenzgas gefüllte Küvette (Gaszelle) in den Lichtweg des Laserspektrometers gebracht. Der Abstimmbereich, d. h. die Wellenlängenänderung bei vorgegebener Strom-Zeit-Funktion (Stromrampe), kann unter Zuhilfenahme eines Etalons festgelegt werden, der ebenfalls in den Lichtweg des Laserspektrometers gebracht wird.

Während die mit dem Referenzgas bzw. Referenzgasgemisch gefüllte Küvette in dem Laserspektrometer verbleiben kann, um, wie oben erläutert, im laufenden Messbetrieb die Position der Referenz-Absorptionslinie in dem detektierten Absorptionsspektrum über die Temperatur der Laserdiode nachzuregeln, ist eine Nachjustierung des Abstimmbereichs im laufenden Messbetrieb unter Verwendung eines Etalons nicht möglich. Die bereits erwähnte Annahme, dass bei Konstanthaltung der Position der Referenz-Absorptionslinie in dem detektierten Absorptionsspektrum auch die Position der Absorptionslinie der zu messenden Gaskomponente konstant bleibt, trifft nur in erster Näherung zu, weil sich bei Alterung der Laserdiode nicht nur ihre Zentralwellenlänge sondern auch ihr Abstimmverhalten über den Strom verändert. So kann sich beispielsweise bei Ansteuerung der Laserdiode mit einer Stromrampe von 30 mA (peak-to-peak) die erzielte Wellenlängenänderung altersbedingt von ursprünglich 40 GHz nach 42 GHz verschieben. Bei Auswertung der interessierenden Absorptionslinie der zu messenden Gaskomponente auf Basis ihrer Fläche würde dies zu einer Änderung des Messergebnisses von etwa 5% führen. Es ist auch möglich, dass aufgrund der veränderten Breite der Absorptionslinie der Auswertealgorithmus nicht mehr zuverlässig funktioniert, wenn z. B. die Auswertung auf einer Multivariantenanalyse basiert, bei der das gemessene Absorptionsspektrum mit vorab aufgenommenen oder berechneten Spektren verglichen wird. Das Problem wird verstärkt, wenn die Laserdiode über einen sehr großen Bereich durchgestimmt wird, so dass die Änderung des Injektionsstroms und die der Wellenlänge nicht mehr proportional zueinander sind. Derart große Abstimmbereiche mit einem nennenswerten nichtlinearen Anteil in der Abstimmungsrate kommen in der Praxis regelmäßig vor. Auch können solche Nichtlinearitäten exemplarabhängig sein, weil sich jede einzelne Laserdiode anders verhält.

Aus der Druckschrift WO 2013/191728 A1 ist eine Analysevorrichtung mit einem einstellbaren Diodenlaser bekannt, bei dem die Wellenlänge des bereitgestellten Lasers einer Drift unterworfen ist. Zur Behebung der Drift werden Kalibrierungsdurchläufe mit einem bekannten Gas durchgeführt, durch die sich Rohdaten für eine Kalibrierung ergeben. Dabei wird eine Stromrampe zur Ansteuerung der Laserdiode variiert.

Bisher wird daher üblicherweise eine regelmäßige Verifikation der Messungen des Laserspektrometers durchgeführt. Entsprechen die Messergebnisse bei der Verifikation nicht mehr den Erwartungen, so wird das Gerät neu- oder nachkalibriert. Je nach Gerät kann dies vom Kunden, vom Service oder nur im Werk durchgeführt werden.

Der Erfindung liegt daher die Aufgabe zugrunde, eine Korrektur der Wellenlänge und des Abstimmbereichs eines Laserspektrometers zu ermöglichen, ohne dies aus dem laufenden Messbetrieb bzw. der Messanordnung herausnehmen zu müssen. Dies gilt insbesondere für In-situ-Messungen, wenn z. B. die Laserdiode und der Detektor in an gegenüberliegenden Stellen einer Prozessgasleitung, eines Abgaskanals usw. montierten Messköpfen untergebracht sind.

Die vorliegende Erfindung ist in Anspruch 1 definiert. Gemäß der Erfindung wird die Aufgabe dadurch gelöst, dass bei dem Verfahren der eingangs angegebenen Art,
- in dem aktuell erhaltenen Absorptionsspektrum die Istposition einer weiteren Absorptionslinie mit der bei einer vorangegangenen einmaligen Justierung des Laserspektrometers detektierten und abgespeicherten Sollposition derselben Absorptionslinie verglichen wird und
- in einem weiteren Korrekturschritt bei einer Abweichung der Istposition der weiteren Absorptionslinie von ihrer Sollposition die Steigung der Stromrampe verändert wird, bis die Istposition der Sollposition entspricht.

Unter der einmaligen Justierung des Laserspektrometers ist neben der erstmaligen werksseitigen Einstellung seiner Wellenlänge und seines Abstimmbereichs auch jede Neu- oder Nachkalibration zu verstehen, die vom Kunden, vom Service oder im Werk durchgeführt wird.

Das erfindungsgemäße Verfahren sieht also vor, in einem ersten Schritt die Zentralwellenlänge der Laserdiode über deren Temperatur und anhand der Position einer von zwei unterschiedlichen ausgewählten, d. h. eindeutig detektierbaren, Absorptionslinien in dem detektierten Absorptionsspektrum nachzujustieren und in einem zweiten Schritt den Abstimmbereich der Laserdiode über die Steigung der Stromrampe so zu korrigieren, dass der Abstand der beiden Absorptionslinien in dem detektierten Absorptionsspektrum gleich bleibt. Da die absoluten Wellenlängen der beiden Absorptionslinien bekannt sind, kann der Abstimmbereich der Laserdiode, d. h. die Wellenlängenänderung bei linearer Strom-Zeit-Funktion (Stromrampe), unmittelbar berechnet werden. Die Korrektur der Wellenlänge und des Abstimmbereichs ist umso genauer und zuverlässiger, je größer der Abstand zwischen den beiden Absorptionslinien ist. Daher werden die beiden Absorptionslinien vorzugsweise so gewählt, dass eine von ihnen möglichst nahe am Anfang und die andere möglichst nahe am Ende des Abstimmbereichs liegt, während z. B. die Absorptionslinie der zu messenden Gaskomponente vorzugsweise in der Mitte des Abstimmbereichs liegt.

Durch die Korrektur des Abstimmbereichs der Laserdiode über die Steigung der Stromrampe kann die zuvor über die Temperatur der Laserdiode korrigierte Zentralwellenlänge wieder verändert werden, so dass beide Korrekturschritte vorzugsweise wiederholt nacheinander ausgeführt werden. Die Rekursion kann gestartet und solange durchgeführt werden, wenn bzw. wie die Abweichungen zwischen den Soll- und Istpositionen vorgegebenen Schwellenwerte überschreiten.

Grundsätzlich könnte die Korrektur der Zentralwellenlänge der Laserdiode anstatt über deren Temperatur dadurch erfolgen, dass ein Strom-Offset auf die Stromrampe addiert wird. Allerdings ändern sich die Abstimmeigenschaften von Laserdioden typischerweise sehr viel stärker bei Änderungen des absoluten Niveaus des Stroms, als bei einer Änderung der Lasertemperatur. Weiterhin müsste man bei vielen Laserdioden eine relativ große Änderung des Stromniveaus verwenden, wohin gegen eine vergleichsweise kleine Temperaturänderung ausreicht. Daher ist für die Korrektur der Zentralwellenlänge in nahezu allen Fällen eine Änderung der Lasertemperatur einer Änderung des Laserstroms vorzuziehen.

Im erfindungsgemäßen Verfahren wird die Stromrampe aus einer Strom-Zeit-Funktion mit einem linearen und mindestens einem nichtlinearen Term gebildet, um Laserdioden mit einem nichtlinearen Abstimmverhalten zu berücksichtigen. Der lineare Funktionsterm entspricht dabei der Steigung der Stromrampe, während der mindestens eine nichtlineare Term einen nichtlinearen Verlauf der Steigung bezeichnet. Beim Durchstimmen der Laserdiode wird dann die Position mindestens einer zwischen den beiden Absorptionslinien liegenden zusätzlichen Absorptionslinie detektiert. Bei einer Abweichung zwischen der aktuell detektierte Istposition dieser zusätzlichen Absorptionslinie und der bei der vorangegangenen einmaligen Justierung des Laserspektrometers detektierten und abgespeicherten Sollposition derselben Absorptionslinie wird in einem zusätzlichen Korrekturschritt der mindestens eine nichtlineare Term verändert wird, bis die Istposition der Sollposition entspricht. Bei dem mindestens einen nichtlinearen Funktionsterm kann es sich im einfachsten Fall um einen quadratischen oder kubischen Term handeln, wobei insbesondere bei sehr großen Abstimmbereichen auch komplexere Terme erforderlich sein können, die das Abstimmverhalten der Laserdiode besser beschreiben. Auch hier kann es nach jedem Ändern des/der nichtlinearen Terms/Terme notwendig sein, die zuvor korrigierten Positionen der anderen Referenz-Absorptionslinien durch Anpassung der Lasertemperatur und des Abstimmbereichs des Stroms nachzukorrigieren.

Die genannten Korrekturschritte werden von dem Laserspektrometer automatisch durchgeführt. Danach stimmt die Laserdiode wieder genau den gleichen Wellenlängenbereich ab, wie sie es bei der Kalibration getan hat. Änderungen des Abstimmverhaltens durch Laseralterung wurden also kompensiert.

Weil die Laseralterung ein sehr langsamer Prozess ist und durch äußere Störeinflüsse und Rauschen überlagert ist, werden die Korrekturschritte in der Praxis nur selten oder nur dann durchgeführt, wenn eine Positionsänderung der betrachten Absorptionslinien gegenüber der Kalibration festgestellt wird, oder es werden nur sehr lange gemittelte Spektren für die Korrektur verwendet. Wie bereits erwähnt, kann die Korrektur der Wellenlänge und des Abstimmbereichs im laufenden Messbetrieb des Laserspektrometers erfolgen, was aber nicht notwendigerweise bedeutet, dass während der Korrektur die interessierende Gaskomponente gemessen wird. Entscheidend bei dem erfindungsgemäßen Verfahren ist, dass die Korrektur automatisch erfolgt und das Laserspektrometer dafür nicht aus dem Messbetrieb oder der Messanordnung herausgenommen werden muss.

Sind die Umgebungsbedingungen (Druck, Temperatur) bei der einmaligen Justierung, z. B. Kalibration, des Laserspektrometers und zum Zeitpunkt der Korrektur seiner Wellenlänge und seines Abstimmbereichs gleich, so können in vorteilhafter Weise ausgewählte Absorptionslinien des Messgasgemischs, ggf. auch die Absorptionslinie der zu messenden Gaskomponente, für die Korrektur verwendet werden. Sobald daher in dem Absorptionsspektrum des Messgasgemischs zwei oder mehr Absorptionslinien sicher gemessen werden können, kann das erfindungsgemäße Verfahren angewendet werden. Dazu ist bei einem vorhandenen Laserspektrometer im Wesentlichen nur eine Funktionserweiterung in der Software erforderlich ist.

Um von den genannten Umgebungsbedingungen unabhängig zu sein, können alternativ, ggf. zusätzlich, Absorptionslinien eines Referenzgases oder -gasgemischs verwendet werden, wobei das in einer Küvette enthaltene Referenzgas und das Messgasgemisch in demselben Lichtweg liegend nacheinander durchstrahlt werden können. Dabei können die Absorptionslinien des Referenzgases mit demselben Detektor detektiert werden, mit dem auch die Absorptionslinie der in dem Messgasgemisch zu messenden Gaskomponente detektiert wird. Alternativ kann bei Anordnung der Küvette mit dem Referenzgas vor dem Messgasgemisch ein Teil des aus dem Referenzgas austretenden Lichts mittels eines Strahlteilers aus dem Lichtweg zu dem Messgasgemisch ausgekoppelt und mit einem weiteren Detektor separat detektiert werden. In diesem Fall ist das separat detektierte Absorptionsspektrum des Referenzgases nicht von dem des Messgasgemischs überlagert. Das detektierte Absorptionsspektrum des Messgasgemischs ist zwar von dem des Referenzgases überlagert, jedoch kann das separat detektierte Absorptionsspektrum des Referenzgases davon subtrahiert werden, so dass auch das Absorptionsspektrum des Messgasgemischs überlagerungsfrei erhalten wird. Alternativ kann die Küvette mit dem Referenzgas zwischen dem Strahlteiler und dem weiteren Detektor angeordnet werden, so dass das detektierte Absorptionsspektrum des Messgasgemischs nicht von dem des Referenzgases überlagert wird.

Das erfindungsgemäße Korrekturverfahren ist sowohl im Falle der direkten Absorptionsspektroskopie als auch im Falle der Wellenlängenmodulationsspektroskopie anwendbar. Während bei der direkten Absorptionsspektroskopie die Konzentration der interessierenden Gaskomponente unmittelbar aus der an der Stelle der Absorptionslinie detektierten Minderung der Lichtintensität (Absorption) bestimmt wird, wird bei der Wellenlängenmodulationsspektroskopie während der vergleichsweise langsamen wellenlängenabhängigen Abtastung der Absorptionslinie zusätzlich die Wellenlänge des erzeugten Lichts mit hoher Frequenz und kleiner Amplitude sinusförmig moduliert. Das Licht wird dann bei einer höheren Harmonischen der Frequenz phasensensitiv detektiert. Entsprechend einer vorteilhaften Weiterbildung des erfindungsgemäßen Verfahrens wird im Falle der Wellenlängenmodulationsspektroskopie proportional mit der Änderung der Steigung oder des nichtlinearen Terms der Stromrampe auch die Amplitude der Wellenlängenmodulation verändert. Alternativ kann nach Änderung der Steigung oder des nichtlinearen Terms der Stromrampe anhand einer der phasensensitiv detektierten Absorptionslinien eine Veränderung des Modulationsverhältnisses ermittelt und in Abhängigkeit davon die Modulationsamplitude korrigiert werden.

Zur weiteren Erläuterung der Erfindung wird im Folgenden auf die Figuren der Zeichnung Bezug genommen; im Einzelnen zeigen
Figur 1 eine schematische Darstellung eines Laserspektrometers, das zur Durchführung des erfindungsgemäßen Verfahrens verwendet werden kann, die Figuren 2 bis 4 weitere Beispiele für Laserspektrometer und die
Figuren 5 bis 9 ein Beispiel für die Auswirkung der Korrektur der Wellenlänge und des Abstimmbereichs des Laserspektrometers auf das detektierte Absorptionsspektrum, wobei Figur 9 die Auswirkung der erfindungsgemäßen Korrektur zeigt.

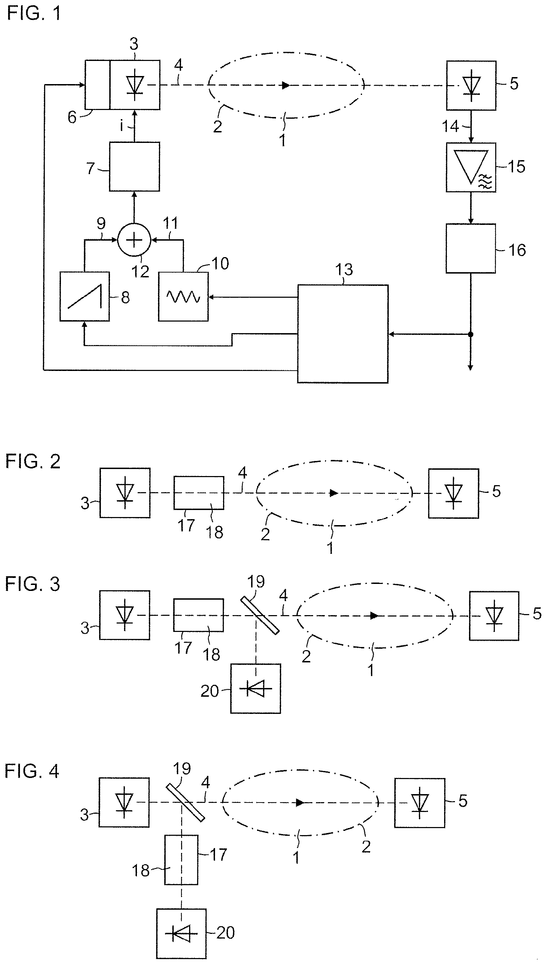

Figur 1 zeigt beispielhaft ein Laserspektrometer zur Messung der Konzentration mindestens einer interessierenden Gaskomponente eines Messgasgemischs 1, das in einem Messvolumen 2, beispielsweise einer Messküvette oder einer Prozessgasleitung, enthalten ist. Das Spektrometer enthält eine Laserdiode 3, deren Licht 4 durch das Messgas 1 auf einen Detektor 5 fällt. Die Laserdiode 3 ist auf einer temperaturgeregelten Wärmesenke 6 montiert und wird von einer steuerbaren Stromquelle 7 mit einem Injektionsstrom i angesteuert. Die Intensität und Wellenlänge des erzeugten Lichts 4 sind von dem Injektionsstrom i und der Betriebstemperatur der Laserdiode 3 abhängig. Die Stromquelle 6 wird von einem ersten Signalgenerator 7 periodisch mit einer rampenförmigen Strom-Zeit-Funktion (Stromrampe) 9 angesteuert, um mit dem entsprechend modulierten Licht 4 eine ausgewählte Absorptionslinie einer interessierenden Gaskomponente des Messgasgemischs 1 abzutasten. Die Strom-Zeit-Funktion 9 kann neben einem die Steigung der Stromrampe angebenden linearen Funktionsterm (Parameter) einen oder weitere Funktionsterme aufweisen, die eine nichtlineare Verformung der Stromrampe bewirken. Ein zweiter Signalgenerator 10 erzeugt ein sinusförmiges Signal (Modulationssignal) 11 der Frequenz f, mit dem in einem Summierglied 12 die Stromrampe 9 moduliert wird.

Die Betriebstemperatur der Laserdiode 3, die Funktionsterme der Stromrampe 9 und die Amplitude des Modulationssignals 2 können mittels einer Steuereinrichtung 13 eingestellt werden.

Der Detektor 5 erzeugt in Abhängigkeit von der detektierten Lichtintensität ein Detektorsignal 14, das als Information ein zeitaufgelöstes Absorptionsspektrum des Messgasgemischs 1 enthält. Das Detektorsignal 14 wird in einem frequenzselektiven Verstärker 15 bei der n-ten, vorzugsweise zweiten, Harmonischen der Modulationsfrequenz f verstärkt und in einer nachfolgenden Auswerteeinrichtung 16 phasensensitiv (lock-in) weiterverarbeitet und zu einem Messwert für die Konzentration der interessierenden Gaskomponente des Messgasgemischs ausgewertet.

Die Figuren 2, 3 und 4 zeigen anhand eines Ausschnitts aus Figur 1 unterschiedliche Varianten des Laserspektrometers, bei denen gleichzeitig mit dem Messgasgemisch 1 ein in einer Küvette 17 enthaltenes Referenzgas oder Referenzgasgemisch 18 mit dem Licht 4 der Laserdiode 3 durchstrahlt wird. In den Beispielen der Figuren 2 und 3 liegen die Küvette 17 und das Messvolumen 2 hintereinander in demselben Lichtweg, so dass der Detektor 5 über den Abstimmbereich der Laserdiode 3 sowohl das Absorptionsspektrum des Messgasgemischs 1 als auch das des Referenzgases oder Referenzgasgemischs 18 detektiert. Bei dem Beispiel nach Figur 3 wird ein Teil des aus der Küvette 17 austretenden Lichts 4 mittels eines Strahlteilers 19 aus dem Lichtweg zu dem Messvolumen 2 ausgekoppelt und auf einen weiteren Detektor 20 geführt, der auf diese Weise das Absorptionsspektrum des Referenzgases oder Referenzgasgemischs 18 separat detektiert. Zur Ermittlung der Konzentration der interessierenden Gaskomponente des Messgasgemischs 1 durch die Auswerteeinrichtung 16 kann zuvor, z. B. unmittelbar hinter dem Detektor 5, das separat detektierte Absorptionsspektrum des Referenzgases oder Referenzgasgemischs 18 von dem des Messgasgemischs 1 subtrahiert werden. In dem Beispiel nach Figur 4 ist schließlich die Küvette 17 im Lichtweg zwischen dem Strahlteiler 19 und dem weiteren Detektor 20 angeordnet, so dass das von dem Detektor 5 detektierte Absorptionsspektrum des Messgasgemischs 1 nicht von dem des Referenzgases oder Referenzgasgemischs 18 überlagert ist.

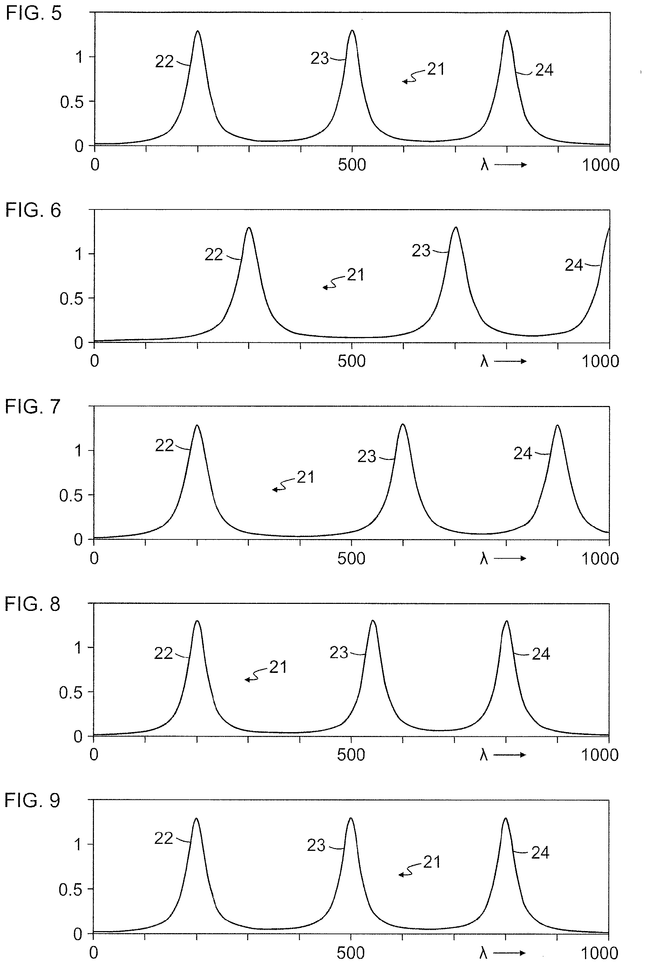

Die Figuren 5 bis 9 zeigen beispielhaft die Auswirkung der Korrektur der Wellenlänge und des Abstimmbereichs des Laserspektrometers auf das detektierte Absorptionsspektrum 21 über den Wellenlängen-Abstimmbereich der Laserdiode 3, der hier auf einen Bereich von 0 bis 1000 normiert ist. Bei dem Absorptionsspektrum 21 kann es sich um das des Messgasgemischs 1 und/oder das des Referenzgases 18 handeln, wobei hier nur die bei dem erfindungsgemäßen Verfahren betrachteten Absorptionslinien 22, 23 und 24 gezeigt sind. Figur 5 zeigt das nach einer Kalibration des Laserspektrometers erhaltene Absorptionsspektrum 21 mit den Sollpositionen der Absorptionslinien 22, 23 und 24.

Figur 6 zeigt dasselbe Absorptionsspektrum 21 nach längerem Gebrauch des Laserspektrometers, wobei sich die Positionen der Absorptionslinien 22, 23 und 24 zu den aktuellen Istpositionen hin verschoben haben.

Figur 7 zeigt, wie anhand der Absorptionslinie 22 durch Änderung der Temperatur der Laserdiode 3 die Istposition dieser Absorptionslinie 22 auf die Sollposition zurückgeschoben wird. Da sich bei Alterung der Laserdiode 3 nicht nur ihre Zentralwellenlänge sondern auch ihr Abstimmverhalten über den Strom verändert hat, weichen die Istpositionen der übrigen Absorptionslinien 23 und 24 nach wie vor von den Sollpositionen ab.

Figur 8 zeigt, wie anhand der Absorptionslinie 24 durch Änderung der Steigung der Stromrampe 9 (linearer Term der Strom-Zeit-Funktion) die Istposition dieser Absorptionslinie 24 auf ihre Sollposition zurückgeschoben wird. Da das Abstimmverhalten der Laserdiode 3 nichtlinear ist, weicht die Istposition der mittleren Absorptionslinie 23 immer noch von ihrer Sollposition ab.

Figur 9 zeigt schließlich, wie erfindungsgemäß anhand der Absorptionslinie 23 durch Änderung des nichtlinearen Terms der Stromrampe 9 auch die Istposition dieser Absorptionslinie 24 auf ihre Sollposition zurückgeschoben wird. Im Ergebnis entsprich das in Figur 5 gezeigte korrigierte Absorptionsspektrum 21 dem nach Figur 1.

Die im Zusammenhang mit den Figuren 7 bis 9 erläuterten Korrekturschritte müssen ggf. mehrfach hintereinander ausgeführt werden.

## Patentansprüche

1. Verfahren zur Korrektur der Wellenlänge und des Abstimmbereichs eines Laserspektrometers, bei dem das Licht einer wellenlängendurchstimmbaren Laserdiode (3) nach Durchstrahlen eines Gases (1, 18) detektiert und ausgewertet wird, wobei die Laserdiode (3) mit einer Stromrampe (9) periodisch angesteuert wird, so dass bei der Detektion des Lichts (4) ein zeitaufgelöstes Absorptionsspektrum des Gases (1, 18) erhalten wird, wobei
- in dem aktuell erhaltenen Absorptionsspektrum die Istposition einer Absorptionslinie (22) des Gases (1, 18) mit der bei einer vorangegangenen einmaligen Justierung des Laserspektrometers detektierten und abgespeicherten Sollposition derselben Absorptionslinie (22) verglichen wird und
- in einem Korrekturschritt bei einer Abweichung der Istposition der Absorptionslinie (22) von der Sollposition die Temperatur der Laserdiode (3) verändert wird, bis die Istposition der Sollposition entspricht und
- in dem aktuell erhaltenen Absorptionsspektrum die Istposition einer weiteren Absorptionslinie (24) mit der bei einer vorangegangenen einmaligen Justierung des Laserspektrometers detektierten und abgespeicherten Sollposition derselben Absorptionslinie (24) verglichen wird und
- in einem weiteren Korrekturschritt bei einer Abweichung der Istposition der weiteren Absorptionslinie (24) von ihrer Sollposition die Steigung der Stromrampe (9) verändert wird, bis die Istposition der Sollposition entspricht;
**dadurch gekennzeichnet, dass** die Stromrampe (9) aus einer Strom-Zeit-Funktion mit einem linearen und mindestens einem nichtlinearen Term gebildet wird,
dass in dem aktuell erhaltenen Absorptionsspektrum die Istposition mindestens einer zwischen der einen und der weiteren Absorptionslinie (22,24) liegenden zusätzlichen Absorptionslinie (23) mit der bei der vorangegangenen einmaligen Justierung des Laserspektrometers detektierten und abgespeicherten Sollposition derselben Absorptionslinie (23) verglichen wird, und
dass in einem auf den weiteren Korrekturschritt folgenden zusätzlichen Korrekturschritt bei einer Abweichung der Istposition der mindestens einen zusätzlichen Absorptionslinie (23) von ihrer Sollposition der mindestens eine nichtlineare Term verändert wird, bis die Istposition der Sollposition entspricht.

2. Verfahren nach Anspruch 1, **dadurch gekennzeichnet, dass** der Korrekturschritt und der weitere Korrekturschritt wiederholt nacheinander ausgeführt werden.

3. Verfahren nach Anspruch 1, **dadurch gekennzeichnet, dass** der Korrekturschritt und der weitere Korrekturschritt in Abhängigkeit davon ausgeführt werden, dass die jeweilige Abweichung zwischen Soll- und Istposition einen vorgegebenen Schwellenwert überschreitet.

4. Verfahren nach einem der vorangehenden Ansprüche, **dadurch gekennzeichnet, dass** es sich bei zumindest einer der für die Korrektur der Wellenlänge und des Abstimmbereichs des Laserspektrometers verwendeten Absorptionslinien (22, 23, 24) um eine ausgewählte Absorptionslinie einer Gaskomponente eines Messgasgemischs (1) handelt, in dem die Konzentration derselben oder einer anderen interessierenden Gaskomponente des Messgasgemischs (1) durch Auswertung einer Absorptionslinie der betreffenden Gaskomponente bestimmt wird.

5. Verfahren nach einem der vorangehenden Ansprüche, **dadurch gekennzeichnet, dass** es sich bei zumindest einer der für die Korrektur der Wellenlänge und des Abstimmbereichs des Laserspektrometers verwendeten Absorptionslinien (22, 23, 24) um eine ausgewählte Absorptionslinie eines Referenzgases oder Referenzgasgemischs (18) handelt.

6. Verfahren nach Anspruch 5, **dadurch gekennzeichnet, dass** das Referenzgas oder Referenzgasgemisch (18) und ein Messgasgemisch (1) gleichzeitig durchstrahlt werden.

7. Verfahren nach Anspruch 6, **dadurch gekennzeichnet, dass** das Referenzgas oder Referenzgasgemisch (18) und das Messgasgemisch (1) in demselben Lichtweg liegend nacheinander durchstrahlt werden und ein Teil des aus dem Referenzgas oder Referenzgasgemisch (18) austretenden Lichts mittels eines Strahlteilers (19) aus dem Lichtweg zu dem Messgasgemisch (1) ausgekoppelt und separat detektiert wird.

8. Verfahren nach Anspruch 7, **dadurch gekennzeichnet, dass** das separat detektierte Spektrum des Referenzgases oder Referenzgasgemischs (18) von dem des Messgasgemischs (1) subtrahiert wird.

9. Verfahren nach Anspruch 5, **dadurch gekennzeichnet, dass** ein Teil des von der Laserdiode (3) kommenden Lichts (4) mittels eines Strahlteilers (19) aus dem Lichtweg zu dem Messgasgemisch (1) ausgekoppelt und nach Durchstrahlen des Referenzgases oder Referenzgasgemischs (18) separat detektiert wird.

10. Verfahren nach einem der vorangehenden Ansprüche, **dadurch gekennzeichnet, dass** die Stromrampe (9) mit einem sinusförmigen Signal (11) vorgegebener Frequenz und Modulationsamplitude moduliert und das Licht (4) bei einer höheren Harmonischen der Frequenz phasensensitiv detektiert wird und dass proportional mit der Änderung der Steigung oder des nichtlinearen Terms der Stromrampe (9) auch die Modulationsamplitude verändert wird.

11. Verfahren nach einem der Ansprüche 1 bis 9, **dadurch gekennzeichnet, dass** die Stromrampe (9) mit einem sinusförmigen Signal vorgegebener Frequenz und Modulationsamplitude moduliert und das Licht (4) bei einer höheren Harmonischen der Frequenz phasensensitiv detektiert wird und dass nach Änderung der Steigung oder des nichtlinearen Terms der Stromrampe (9) anhand einer der phasensensitiv detektierten Absorptionslinien eine Veränderung des Modulationsverhältnisses ermittelt und in Abhängigkeit davon die die Modulationsamplitude korrigiert wird.

## Claims

1. Method for correcting the wavelength and the tuning range of a laser spectrometer, in which the light of a wavelength-tunable laser diode (3) is detected and evaluated after radiating through a gas (1, 18), wherein the laser diode (3) is periodically driven with a current ramp (9), such that a time-resolved absorption spectrum of the gas (1, 18) is obtained upon the detection of the light (4), wherein
- in the absorption spectrum currently obtained the actual position of an absorption line (22) of the gas (1, 18) is compared with the target position of the same absorption line (22) detected and stored in a preceding one-off adjustment of the laser spectrometer and
- in a correction step, with a deviation of the actual position of the absorption line (22) from the target position, the temperature of the laser diode (3) is changed until the actual position corresponds to the target position, andin the absorption spectrum currently obtained, the actual position of a further absorption line (24) is compared with the target position of the same absorption line (24) detected and stored in a preceding one-off adjustment of the laser spectrometer and
- in a further correction step, with a deviation of the actual position of the further absorption line (24) from its target position, the gradient of the current ramp (9) is changed until the actual position corresponds to the target position;
**characterised in that** the current ramp (9) is formed from a current-time function with one linear and at least one non-linear term,
in the absorption spectrum currently obtained, the actual position of at least one additional absorption line (23) lying between the one and the further absorption line (22, 24) is compared with the target position of the same absorption line (23) detected and stored in the preceding one-off adjustment of the laser spectrometer, and
in an additional correction step following the further correction step, with a deviation of the actual position of the at least one additional absorption line (23) from its target position, the at least one non-linear term is changed until the actual position corresponds to the target position.

2. Method according to claim 1, **characterised in that** the correction step and the further correction step are carried out repeatedly after one another.

3. Method according to claim 1, **characterised in that** the correction step and the further correction step are carried out as a function of the respective deviation between target position and actual position exceeding a predetermined threshold value.

4. Method according to one of the preceding claims, **characterised in that**
the at least one absorption line (22, 23, 24) used for the correction of the wavelength and of the tuning range of the laser spectrometer involves a selected absorption line of a gas component of a measurement gas mixture (1), in which the concentration of the same or of another gas component of interest of the measurement gas mixture (1) is determined by evaluation of an absorption line of the gas component concerned.

5. Method according to one of the preceding claims, **characterised in that** at least one of the absorption lines (22, 23, 24) used for the correction of the wavelength and of the tuning range of the laser spectrometer involves a selected absorption line of a reference gas or reference gas mixture (18) .

6. Method according to claim 5, **characterised in that** there is simultaneous radiation through the reference gas or reference gas mixture (18) and through a measurement gas mixture (1).

7. Method according to claim 6, **characterised in that** the reference gas or reference gas mixture (18) and the measurement gas mixture (1) lying in the same light path are radiated through after one another and a part of the light emerging from the reference gas or reference gas mixture (18) is coupled out by means of a beam splitter (19) from the light path to the measurement gas mixture (1) and detected separately.

8. Method according to claim 7, **characterised in that** the separately detected spectrum of the reference gas or reference gas mixture (18) is subtracted from that of the measurement gas mixture (1).

9. Method according to claim 5, **characterised in that** a part of the light (4) coming from the laser diode (3) is coupled out by means of a beam splitter (19) from the light path to the measurement gas mixture (1) and is detected separately after radiating through the reference gas or reference gas mixture (18).

10. Method according to one of the preceding claims, **characterised in that** the current ramp (9) is modulated with a sinusoidal signal (11) of predetermined frequency and modulation amplitude and the light (4) is detected phase-sensitively at a higher harmonic of the frequency and that the modulation amplitude is also changed in proportion with the change in the gradient or in the non-linear term of the current ramp (9).

11. Method according to one of claims 1 to 9, **characterised in that** the current ramp (9) is modulated with a sinusoidal signal of predetermined frequency and modulation amplitude and the light (4) is detected phase-sensitively at a higher harmonic of the frequency and that after the gradient or the non-linear term of the current ramp (9) is changed on the basis of the phase-sensitively detected absorption lines, a change in the modulation ratio is established and the modulation amplitude is corrected as a function thereof.

## Revendications

1. Procédé de correction de la longueur d'onde et de la gamme d'accord d'un spectromètre à laser, dans lequel on détecte et on exploite, après traversée d'un gaz (1, 18), la lumière d'une diode (3) laser de longueur d'onde variable, dans lequel on commande périodiquement la diode (3) laser par une rampe (9) de courant, de manière à obtenir, à la détection de la lumière (4), un spectre du gaz (1, 18) en résolution temporelle, dans lequel
- dans le spectre d'absorption obtenu instantanément, on compare la position réelle d'une raie (22) d'absorption du gaz (1, 18) à la position de consigne de la même raie (22) d'absorption détectée lors d'un réglage unique précédent du spectromètre à laser et mise en mémoire, et
- dans un stade de correction, s'il y a un écart de la position réelle de la raie (22) d'absorption à la position de consigne, on modifie la température de la diode (3) laser, jusqu'à ce que la position réelle corresponde à la position de consigne, et
- dans le spectre d'absorption obtenu instantanément, on compare la position réelle d'une autre raie (24) d'absorption à la position de consigne de la même raie (24) d'absorption détectée lors d'un réglage unique précédent du spectromètre à laser et mise en mémoire, et
- dans un autre stade de correction, s'il y a un écart de la position réelle de l'autre raie (24) d'absorption à sa position de consigne, on modifie la pente de la rampe (9) de courant, jusqu'à ce que la position réelle corresponde à la position de consigne ;
**caractérisé en ce que** l'on forme la rampe (9) de courant à partir d'une fonction courant-temps ayant un terme linéaire et au moins un terme non linéaire,
**en ce que**, dans le spectre d'absorption obtenu instantanément, on compare la position réelle d'au moins une raie (23) d'absorption supplémentaire se trouvant entre la une et l'autre raie (22, 24) d'absorption à la position de consigne de la même raie (23) d'absorption détectée lors d'un réglage unique précédent du spectromètre à laser et mise en mémoire, et
**en ce que**, dans un stade de correction supplémentaire suivant l'autre stade correction, s'il y a un écart de la position réelle de la au moins une raie (23) d'absorption supplémentaire à sa position de consigne, on modifie le au moins un terme non linéaire, jusqu'à ce que la position réelle corresponde à la position de consigne.

2. Procédé suivant la revendication 1, **caractérisé en ce que** l'on effectue le stade correction et l'autre stade de correction l'un après l'autre de manière répétée.

3. Procédé suivant la revendication 1, **caractérisé en ce que** l'on effectue le stade de correction et l'autre stade de correction en fonction du point de savoir si l'écart respectif entre position de consigne et position réelle dépasse une valeur de seuil donnée à l'avance.

4. Procédé suivant l'une des revendications précédentes, **caractérisé en ce qu'**au moins l'une des raies (22, 23, 24) d'absorption utilisée pour la correction de la longueur d'onde et de la gamme d'accord du spectromètre à laser est une raie d'absorption sélectionnée d'un constituant gazeux d'un mélange (1) gazeux à mesurer, dans lequel la concentration du même ou d'un autre constituant gazeux intéressant du mélange (1) gazeux de mesure est déterminée par exploitation d'une raie d'absorption du constituant gazeux concerné.

5. Procédé suivant l'une des revendications précédentes, **caractérisé en ce qu'**au moins l'une des raies (22, 23, 24) d'absorption utilisée pour la correction de la longueur d'onde et de la gamme d'accord du spectromètre à laser est une raie d'absorption sélectionnée d'un gaz de référence ou d'un mélange (18) gazeux de référence.

6. Procédé suivant la revendication 5, **caractérisé en ce que** l'on fait passer la lumière en même temps dans le gaz de référence ou le mélange (18) gazeux de référence et dans un mélange (1) de gaz de mesure.

7. Procédé suivant la revendication 6, **caractérisé en ce que** l'on fait passer la lumière suivant le même chemin lumineux l'un après l'autre dans le gaz de référence ou le mélange (18) gazeux de référence et dans le mélange (1) gazeux de mesure et on extrait et on détecte séparément, du chemin de la lumière allant au mélange (1) gazeux de mesure, au moyen d'un diviseur (19) de faisceau, une partie de la lumière sortant du gaz de référence ou du mélange (18) gazeux de référence.

8. Procédé suivant la revendication 7, **caractérisé en ce que** l'on soustrait le spectre détecté séparément du gaz de référence ou du mélange (18) gazeux de référence de celui du mélange (1) gazeux de mesure.

9. Procédé suivant la revendication 5, **caractérisé en ce que** l'on extrait du chemin de la lumière allant au mélange (1) gazeux de mesure au moyen d'un diviseur (19) de faisceau, une partie de la lumière (4) venant de la diode (3) laser et on la détecte séparément, après traversée du gaz de référence ou du mélange (18) gazeux de référence.

10. Procédé suivant l'une des revendications précédentes, **caractérisé en ce que** l'on module la rampe (9) de courant par un signal (11) sinusoïdal de fréquence et d'amplitude de modulation données à l'avance et on détecte, d'une manière sensible à la phase, la lumière (4) pour un harmonique supérieur de la fréquence et **en ce que** l'on modifie également l'amplitude de modulation proportionnellement à la variation de la pente ou du terme non linéaire de la rampe (9) de courant.

11. Procédé suivant l'une des revendications 1 à 9, **caractérisé en ce que** l'on module la rampe (9) de courant par un signal sinusoïdal de fréquence et d'amplitude de modulation données à l'avance et **en ce que** l'on détecte, d'une manière sensible à la phase, la lumière (4) pour un harmonique supérieur de la fréquence et **en ce que**, après variation de la pente ou du terme non linéaire de la rampe (9) de courant, on détermine, à l'aide de l'une des raies d'absorption détectées, de manière sensible à la phase, une modification du rapport de modulation et on corrige l'amplitude de modulation en fonction de cela.
